# EUROPEAN PATENT SPECIFICATION

(11) **EP 2 230 886 B1**
(45) Date of publication and mention of the grant of the patent: **22.04.2020**
(21) Application number: 10151638.3
(22) Date of filing: 26.01.2010
(51) Int. Cl.: H05B 33/08, H05B 33/00

(54) **AC-driven light emitting device**
Wechselstromangetriebene lichtemittierende Vorrichtung
Dispositif électroluminescent à alimentation CA

(30) Priority: 19.03.2009 US 161423 P
(43) Date of publication of application: 22.09.2010
(73) Proprietor: Epistar Corporation, Hsinchu 300 (TW)
(72) Inventor: Su, Hwa, 106, Taipei City (TW); Chou, Hsi-Yan, Taipei City 115 (TW); Li, Yu-Min, Taoyuan County 320 (TW); Hu, Yu-Chon, Mingjian Township Nantou County 551 (TW); Huang, Chih-Wei, Linyuan Township Kaohsiung County 832 (TW); Cheng, Tzu-Chi, Taoyuan County 330 (TW)
(74) Representative: Ter Meer Steinmeister & Partner

(56) References cited:
- EP-A1- 1 874 097
- WO-A1-99/20085
- WO-A1-2007/023454
- US-A- 4 182 977
- US-A1- 2003 234 342
- US-A1- 2007 200 512

## Description

### BACKGROUND OF THE INVENTION

### 1. Field of the Invention

The present invention relates to an alternate current driven (AC-driven) light emitting device, in particular to an AC-driven light emitting device having at least one direct current driven (DC-driven) LED chip group and at least one AC-driven LED chip to achieve a structure with the features of a stable voltage, an enhanced color rendering and an improved light emitting efficiency.

### 2. Description of Related Art

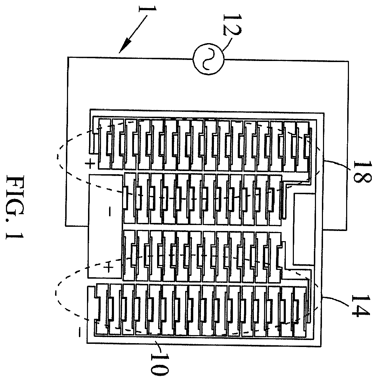

With reference to Fig. 1 for a schematic view of a light emitting diode (LED) array as disclosed in U.S. Pat. No. 6,957,899, the LED array 1 comprises an AC power supply device 12, a first LED array 14 and a second LED array 18. In Fig. 1, the first LED array 14 and the second LED array 18 are composed of a plurality of micro-LED chips connected in series with each other and arranged on a same plane 10. A positive half wave period is applied to drive the first LED array 14 to emit light, and a negative half wave period is applied to drive the second LED array 18 to emit light. In general, the utility power of each different country has an AC frequency of 50∼60Hz which is greater than the frequency required for the duration of vision of human beings, so that we cannot visually distinguish alternate light emissions of the first and second LED arrays 14, 18 in the LED array 1 and the aforementioned invention fails to achieve an expected practical application.

At present, the yield rate of the GaN LED chips is unable to guarantee a uniform brightness or a 100% light emitting efficiency of each micro-LED chip, such that if an AC voltage is applied to drive the first LED array 14 to emit light, then light and heat will be generated. Therefore, the temperature and voltage will be deviated easily to cause a non-uniform light emission. If an additional AC voltage produces a surge, the LED chip in the light emitting device may be burned easily, and the reliability will become a big issue as well as a major drawback of the lowest-layer LED array.

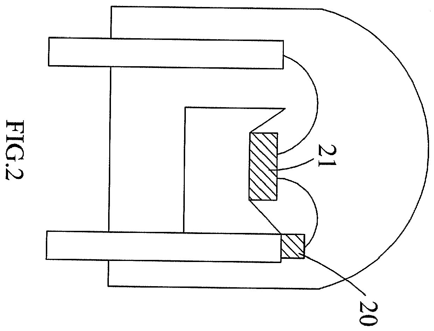

To overcome the aforementioned drawback of the GaN LED chip disclosed in U.S. Pat. No. 6,957,899, a light emitting device as shown in Fig. 2 is disclosed in R.O.C. Pat. Publication No. 200826320, wherein the light emitting device comprises at least one correction circuit 20 to serve as a temperature and voltage compensation circuit provided for the operation of an AC-driven light emitting diode component 21 and achieve the effect of absorbing surges. However, the aforementioned invention still has a drawback of failing to compensate the color rendering during a light emission.

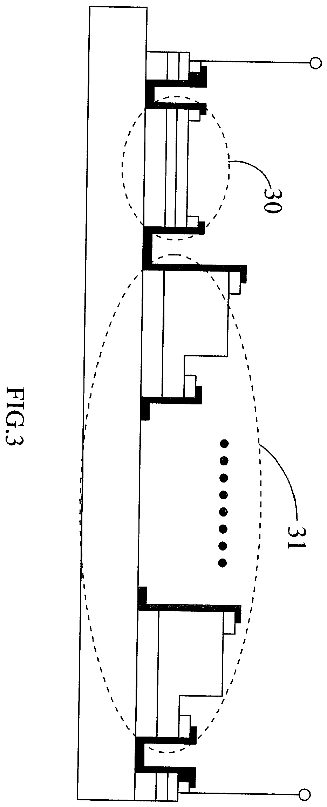

With reference to Fig. 3 for a schematic view of a lowest-layer LED element disclose in U.S. Application Publication No. 2008083929, at least one current limit resistor 30 is added in an LED chip fabrication process to improve the reliability of operating an AC or DC driven light emitting diode element in order to protect an LED array 31. However, the current limit resistor 30 still has the drawbacks of failing to emit lights or to achieve the effect of compensating the color rendering.

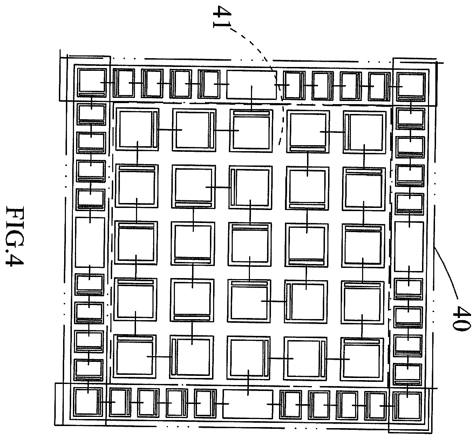

With reference to Fig. 4 for a schematic view of a lowest-layer light emitting element disclosed in U.S. Publication No. 2008218098, a bridge rectifying circuit 40 composed of another set of light emitting diodes is added to improve the reliability of operating an AC-driven light emitting diode element and protect an LED array 41. However, the bridge rectifying circuit 40 is directly formed on a substrate used by the LED array 41 and disposed at an external edge. In other words, the LED array 41 and the bridge rectifying circuit 40 are produced in a same chip fabrication process, and the bridge rectifying circuit 40 not only provides an AC-to-DC conversion function, but also has the function of emitting light. However, this method is unable to produce a light emitting diode assembly with different light emission wavelengths on the same substrate by the chip fabrication process, and thus the method still has the drawback of failing to provide the effect of compensating the color rendering. In view of the aforementioned shortcomings of the prior art, the inventor of the present invention based on years of experience in the related industry to conduct extensive researches and experiments, and finally developed a light emitting device according to the present invention to overcome the shortcomings of the prior art.

Such a light emitting device is neither disclosed nor suggested in any in the cited documents.

Document D1 (WO 99/20085 A1) discloses an electric lamp circuit and structure using light emitting diodes which comprises a plurality of LEDs arranged in a matrix form and a bridge rectifier which through-wave rectifies an AC voltage from a power source to supply a direct current voltage to the plurality of LEDs of a light emitting circuit. The bridge rectifier comprises conventional dials.

Document D2 (US 4 182 977 A) discloses a DC-driven light emitting device with LEDs which comprises a current limiting circuit tree.

Document D3 (WO 2007/023454 A1) discloses a LED light source for backlighting in which different sets of LEDs are each connected in series with voltage regulator and a countable current source.

### SUMMARY OF THE INVENTION

It is an object of the present invention to provide a light emitting device comprising a lead frame, at least one AC-driven LED area and at least one compensation circuit which guarantees a uniform brightness, reliability and stable color rendering.

This object is achieved by the light emitting device according to claim 1.

A serial bridge compensation circuit composed of an AC-driven LED chip and independent to a package structure of the AC-driven LED chip not only provides a stable voltage and a color rendering compensation effect, but also improves the light emitting efficiency of the AC-driven light emitting device.

To make it easier to fully understand the technical characteristics and the effects of the present invention, we use preferred embodiments and related drawings for the detailed description of the present invention as follows.

### BRIEF DESCRIPTION OF THE DRAWINGS

- Fig. 1: is a schematic view of a lowest-layer LED array;
- Fig. 2: is a schematic view of a lowest-layer LED device;
- Fig. 3: is a schematic view of a lowest-layer LED element;
- Fig. 4: is a schematic view of a lowest-layer light emitting element;
- Fig. 5: is a schematic view of a package structure of the present invention;
- Fig. 6: is a cross-sectional view of a circuit design of a lead frame of the present invention;
- Fig. 7: is a schematic view of an equivalent circuit in accordance with a preferred embodiment of the present invention;
- Fig. 8: is a perspective view of a component layout in accordance with a preferred embodiment of the present invention;
- Fig. 9: is a schematic view of a first LED chip in accordance with a preferred embodiment of the present invention;
- Fig. 10: is a schematic view of another preferred embodiment of the present invention; and
- Fig. 11: is a schematic view of an example.

### DETAILED DESCRIPTION OF THE PREFERRED EMBODIMENTS

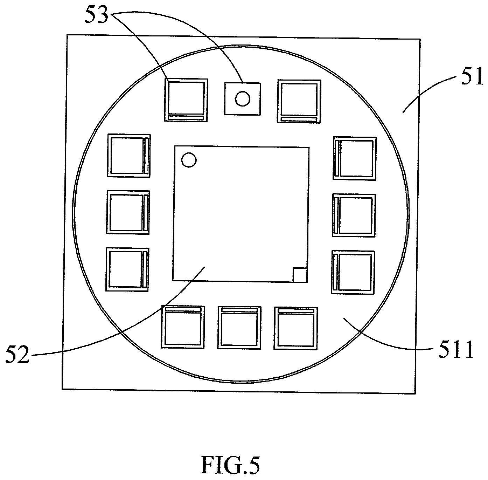

With reference to Fig. 5 for a schematic view of a package structure of the present invention, the invention comprises a lead frame 51, a first LED chip 52 and at least one second LED chip 53 independent of the first LED chip 52. The lead frame 51 includes a notch area 511 provided for die bonding and wire bonding the first LED chip 52 and the second LED chip 53, and a circuit and a conductive wire for providing an electric connection. The first LED chip 52 is formed by serially connecting a plurality of micro-LED chips, and the first LED chip 52 constitutes a conventional AC-driven LED chip, particularly an assembly unit formed by connecting two micro chips with opposite electrodes and installed at a central area of the notch area 511. The second LED chip 53 is a lowest-layer AC-driven LED chip installed at an external edge area of the notch area 511.

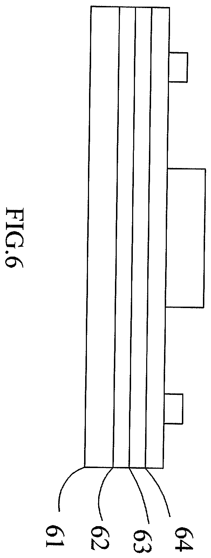

With reference to Fig. 6 for a cross-sectional view of a circuit design of a lead frame of the present invention, the lead frame 51 is made of a ceramic based, aluminum nitride based (AlN-based) or aluminum oxide based (AlO-based) composite material, wherein the lowermost-layer circuit 61 is a circuit having a plurality of bonding pads with a main function of providing a compatible lowest-layer surface mount technology (SMT) process to the light emitting device 50, such that the light emitting device 50 can be modularized directly in a conventional printed circuit board. Two middle-layer circuits 62, 63 are circuits required for bridging the second LED chip 53 and connecting the second LED chip 53 and the first LED chip 52. An uppermost-layer circuit 64 is a circuit required for die bonding and wire bonding the first LED chip 52 and the second LED chip 53.

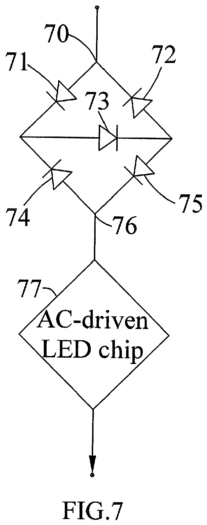

With reference to Fig. 7 for a schematic view of an equivalent circuit in accordance with a preferred embodiment of the present invention, five second LED chips 71, 72, 73, 74, 75 are connected by a bridge method, such that if an AC-driven positive half wave period is applied, then a current flows from a node 70 through the second LED chips 71, 73, 75 to a node 76 and connects a first LED chip 77. If an AC-driven negative half wave period is applied, then the current flows from the node 70 through the second LED chips 72, 73, 74 to the node 76 and connects the first LED chip 77. Since the five second LED chips 71, 72, 73, 74, 75 are connected by the bridge method, the invention not just achieves the voltage compensation effect only, but also maps an external driven current to emit a light having a wavelength equal to or unequal to that of the first LED chip 77 (since it is a light emitting diode), so as to provide a color rendering compensation effect for an application of the white light emitting device.

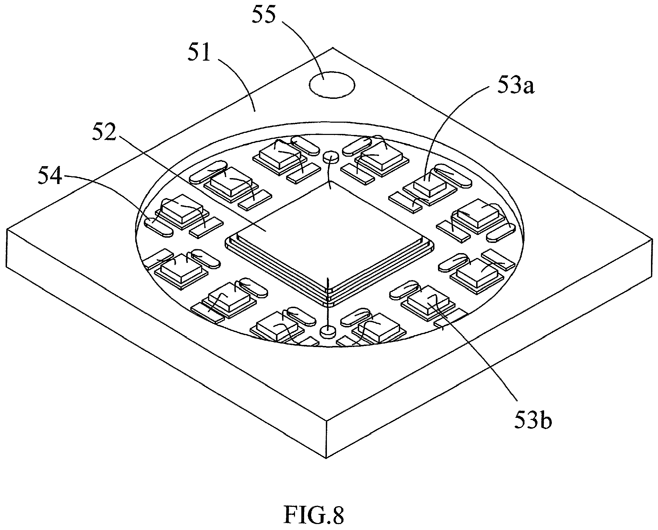

With reference to Fig. 8 for a schematic view of a component layout in accordance with a preferred embodiment of the present invention, the invention comprises a lead frame 51, a first LED chip 52, a vertical-electrode second LED chip 53a, a transverse-electrode second LED chip 53b, a bonding pad circuit 54 and a marker 55 disposed on the lead frame 51.

The objectives, technical characteristics and advantages of the present invention will become apparent with the detailed description of the following preferred embodiments together with related drawings as follows.

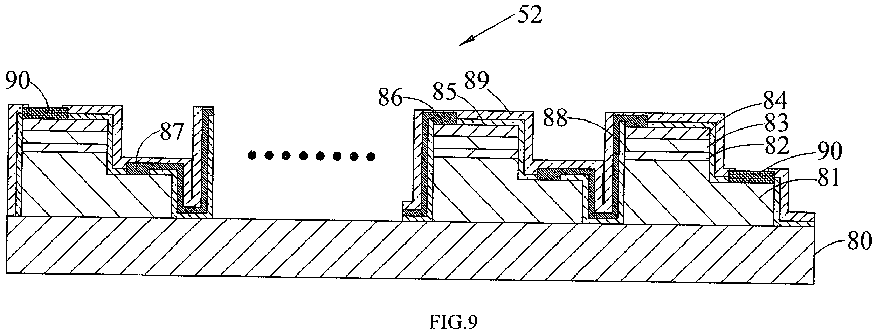

With reference to Fig. 9, at least one N-type GaN layer 81, a GaInN light emitting layer 82 and a P-type GaN layer 83 are grown sequentially on a sapphire substrate 80 of the first LED chip 52 by a metal organic chemical vapor deposition process or an electron beam epitaxy process to form an epitaxial wafer. A photolithography and an etching process are adopted to remove the portions of the P-type GaN layer 83, GaInN light emitting layer 82 and N-type GaN layer 81 to expose an insulating sapphire substrate 80 to isolate the electric connection of each independent micro chip. A transparent conductive layer 84 is formed on the P-type GaN layer, and the photolithography and etching process are repeated to remove the portions of the transparent conductive layer 84, P-type GaN layer 83, GaInN light emitting layer 82 and N-type GaN layer 81 to expose the N-type GaN layer as an ohm contact layer, and then SiO2, Si3N4 or SOG is deposited to serve as a first insulating layer 85 for the electric isolation required for the electrode bridge process of each independent micro chip on the sapphire substrate 80. An ohm-contact anode 86 and an ohm-contact cathode 87 are formed on the transparent conductive layer 84 and the N-type GaN layer 81 to form serial electrodes 88 for connecting an anode and a cathode of different micro chips respectively, so as to produce a conventional GaN LED chip array of a transverse electrode distribution. Another second insulating protection layer 89 is formed on the chip array and anode and cathode bonding pads 90 of the first LED chip 52 are exposed. Finally, the wafer goes through a grinding process and a dicing process to form each independent first LED chip 52. In addition, the vertical-electrode second LED chip 53 is formed by a GaInAIP-based, GaAlAs/GaAs-based, GaAsP/GaP-based or GaInN/SiC lowest-layer through another different process. The transverse electrode second LED chip 53b is fabricated by the same method of the first LED chip 52, except that another different process is adopted. Since the LED chips are separated from each other, no electrode bridge process is involved.

In general, the yield rate of the present light emitting diode process cannot guarantee that each independent first LED chip 52 has the same photoelectric properties, and thus the same AC current value cannot be obtained in the same DC current testing. As a result, it is necessary to classify the LED chips according to the AC current value. For example, the first LED chip 52 is composed of 40 micro chips, and if an AC-driven positive or negative half wave period (or an equivalent DC driving) is used, only approximately 28 micro chips will emit lights. If 10mA forward DC current is used for testing each conventional GaN micro chip and the forward AC current value of each micro chip is equal to 3.7 volts, then the accumulated voltage of 28 micro chips will be equal to 103.6 volts approximately. If 10ma forward DC current is used for testing each GaN micro chip and the forward AC current value of each micro chip is equal to 4.0 volts, then the accumulated voltage of 28 micro chips will be equal to 112 volts approximately. As described above, the photoelectric properties of each micro chip slight have a slight difference, and thus the accumulated voltage of the micro chips of each first LED chip 52 is not consistent, and it is necessary to classify the first LED chip 52 according to a voltage range in an AC application. For example, a voltage of 100.1∼102.5 volts is classified as one type, and a voltage of 102.6∼105 volts is classified as another type, and so on.

However, a general AC utility power with a specification of 110 volts or 220 volts refers to a root mean square (RMS) value represented by Vrms, which is equivalent to a peak voltage Vp of 155.5 volts or 311.1 volts. If the general AC utility power of 110 volts is applied to the first LED chip 52 of 102.6∼105 volts, each micro chip will be distributed with a peak voltage of approximately 5.55volts, and thus an over-current is passed through each micro chip to burn the light emitting device. With reference to Fig. 7, the second LED chips 71, 72, 73, 74, 75 are added in the packaging process and connected by a bridge method, wherein each second LED chip 71, 73, 75 comprises one LED chip for controlling the positive half wave period driving current of the light emitting device at 10mA. On the other hand, each second LED chip 72, 73, 74 comprises one LED chip for controlling the driving current of the positive half wave period of the light emitting device at 10mA similarly, to overcome the aforementioned problems and achieve the voltage compensation effect.

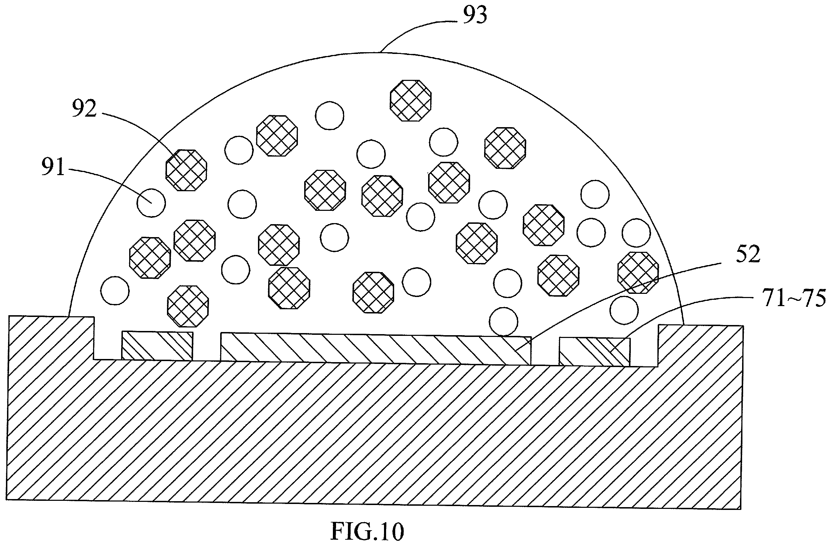

With reference to Fig. 10 for a schematic view of another preferred embodiment of the present invention, this preferred embodiment provides a first LED chip 52 made of GaN and having a light emission wavelength of a blue wave band (455nm∼460nm) and AC-driven second LED chips 71, 72, 73, 74, 75 having a light emission wavelength of another blue wave band (490nm∼510nm), wherein a YAG phosphor powder 91, a silicate-based phosphor powder 92 and a silicon encapsulation material 93 are mixed uniformly and packaged onto the chip and the lead frame, such that the YAG phosphor powder 91 can absorb the portion of the light of the blue wave band (455nm∼460nm) and emit a light with a wavelength of a green wave band (550nm∼570nm), and the silicate-based phosphor powder 92 can absorb the light of a blue wave band (490nm∼510nm) and emit a light with a wavelength of a red wave band (620nm∼650nm). A white light emitting device with a color rendering compensation effect can be achieved by mixing the three wavelengths of the blue wave band (455nm∼460nm and 490nm∼510nm), the green wave band (550nm∼570nm) and the red wave band (620nm∼650nm). In addition, activators in the silicate-based phosphor powder or nitride-based phosphor powder can be adjusted to substitute the YAG phosphor powder 91 or the silicate-based phosphor powder 92 to achieve the effect of the present invention.

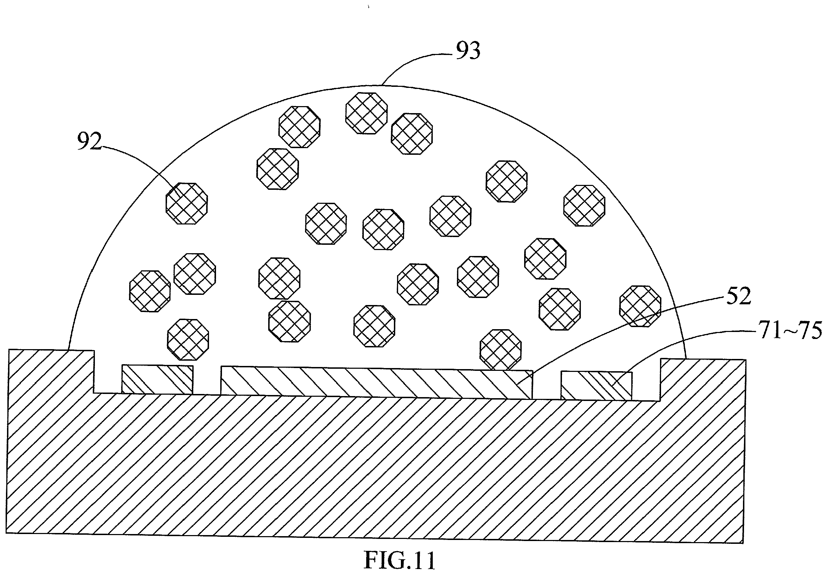

With reference to Fig. 11 for a schematic view of an example, this example provides a first LED chip 52 made of GaN and having a light emission wavelength of a blue wave band (455nm∼460nm), and an AC-driven second LED chip 71, 72, 73, 74, 75 made of an InN-based, GaInAIP-based, GaAlAs-based, GaAIP-based or GaP-based semiconductor material and having a light emission wavelength of a red wave band (620nm∼670nm), wherein a silicate-based phosphor powder 92 and a silicon encapsulation material 93 are mixed uniformly and packaged on the chip and the lead frame, such that the silicate-based phosphor powder 92 can absorb the portion of the light at the blue wave band (455nm∼460nm) to emit a light with a wavelength of a green wave band (550nm∼570nm). A white light emitting device with a color rendering compensation effect can be achieved by mixing the three wavelengths of the blue wave band (455nm∼460nm), the green wave band (550nm∼570nm) and the red wave band (620nm∼670nm). In addition, activators in the silicate-based phosphor powder or nitride-based phosphor powder can be adjusted to substitute the YAG phosphor powder 91 or the silicate-based phosphor powder 92 to achieve the effect of the present invention.

While the invention has been described by means of specific embodiments, numerous modifications and variations could be made thereto by those skilled in the art without departing from the scope of the invention set forth in the claims. For example, the present invention further provides an electrostatic discharge protection circuit connected in parallel with the AC-driven LED chip or the group of AC-driven LED chips.

## Claims

1. A light emitting device configured to be driven by an alternate current, AC, having positive and negative half wave periods, the light emitting device, comprising:
- a lead frame (51),
- at least one first LED chip (52, 77) formed on the lead frame (51); and
- a compensation circuit;
**characterized in that**
- the compensation circuit comprises a plurality of second LED chips (53, 71-75) arranged as a bridge rectifier circuit on the lead frame (51) and electrically connected to the first LED chip (52, 77) in series, wherein the plurality of second LED chips (53, 71-75) is separated from the at least one first LED chip (52, 77);
- the at least one first LED chip (52, 77) is made of GaN and is configured to emit a light emission wavelength of a first blue wave band within 455nm and 460nm and the plurality of second LED chips (53, 71-75) is configured to emit a light emission wavelength of a second blue wave band within 490nm and 510nm;
- the light emitting device further comprising:
- a YAG phosphor powder (91), a silicate-based phosphor powder (92) and a silicon encapsulation material (93) mixed uniformly and packed onto the at least one first LED chip (52, 77) and the plurality of second LED chips (52, 71-75) and the lead frame (51),
- wherein the YAG phosphor powder (91) is configured to absorb a portion of light of the first blue wave band emitted from the at least one first LED chips (52, 77) and to emit a light with a wavelength of a green wave band within 550nm and 570nm,
- wherein the silicate-based phosphor powder (92) is configured to absorb a light of the second blue wave band emitted from the plurality of second LED chips (53, 71-75) and to emit a light with a wavelength of a red wave band within 620nm to 650nm,
- wherein a white light emitting device with a color rendering compensation effect is achieved by mixing the wavelengths of the first blue wave band and the second blue wave band, the green wave band and the red wave band.

2. The light emitting device of claim 1, wherein when an alternate current, AC, is applied to drive the light emitting device, a first part of the plurality of second LED chips (71-75) is configured to control a positive half wave period applied to the at least one first LED chip (77), and a second part of the plurality of second LED chips (71-75) is configured to control a negative half wave period applied to the at least one first LED chip (77), thereby achieving a voltage compensation effect.

3. The light emitting device of claim 1, wherein the at least one first LED chip (52, 77) is formed by serially connecting a plurality of micro-LED chips.

4. The light emitting device of claim 3, wherein the serially connected micro-LED chips refer to an assembly unit formed by connecting two microchips with opposite electrodes.

5. The light emitting device of claim 4, wherein the two micro chips having oppositely connected electrodes and are configured to emit lights alternately.

6. The light emitting device of claim 1, wherein the plurality of second LED chips (53, 71 75) and the at least one first LED chip (52, 77) are manufactured on different substrates respectively.

7. The light emitting device of claim 6, wherein the plurality of second LED chips (53, 71-75) is made of a GaN-based semiconductor material.

8. The light emitting device of claim 5, wherein the plurality of second LED chips (53, 71-75) is made of a semiconductor material selected from the collection of an InN-based compound, a GalnAIP-based compound, a GaAlAs-based compound, a GaAlP-based compound and a GaP-based com-pound.

9. The light emitting device of claim 2, wherein the lead frame (51) includes a plurality of printed circuits having bonding pads.

## Patentansprüche

1. Lichtemittierende Vorrichtung, die konfiguriert ist, durch einen Wechselstrom, AC, der Zeiträume einer positiven und einer negativen Halbwelle besitzt, angesteuert zu werden, wobei die lichtemittierende Vorrichtung Folgendes umfasst:
- einen Leiterrahmen (51),
- mindestens einen ersten LED-Chip (52, 77), der am Leiterrahmen (51) gebildet ist; und
- eine Ausgleichsschaltung;
**dadurch gekennzeichnet, dass**
- die Ausgleichsschaltung mehrere zweite LED-Chips (53, 71-75) umfasst, die als eine Brückengleichrichterschaltung am Leiterrahmen (51) angeordnet sind und mit dem ersten LED-Chip (52, 77) elektrisch in Reihe geschaltet sind, wobei die mehreren zweiten LED-Chips (53, 71-75) vom mindestens einen ersten LED-Chip (52, 77) getrennt sind;
- der mindestens eine erste LED-Chip (52, 77) aus GaN hergestellt ist und konfiguriert ist, eine Lichtemissionswellenlänge eines ersten blauen Wellenbands im Bereich von 455 nm bis 460 nm abzustrahlen, und die mehreren zweiten LED-Chips (53, 71-75) konfiguriert sind, eine Lichtemissionswellenlänge eines zweiten blauen Wellenbands im Bereich von 490 nm bis 510 nm abzustrahlen; und
- die lichtemittierende Vorrichtung ferner Folgendes umfasst:
- ein YAG-Phosphorpulver (91), ein silikatbasiertes Phosphorpulver (92) und ein Siliziumkapselungsmaterial (93), die gleichmäßig gemischt sind und auf den mindestens einen ersten LED-Chip (52, 77) und die mehreren zweiten LED-Chips (52, 71-75) und den Leiterrahmen (51) gepackt ist, wobei
- das YAG-Phosphorpulver (91) konfiguriert ist, einen Teil des Lichts des ersten blauen Wellenbands, der von dem mindestens einen ersten LED-Chip (52, 77) abgestrahlt wird, zu absorbieren und Licht mit einer Wellenlänge eines grünen Wellenlängenbands im Bereich von 550 nm bis 570 nm abzustrahlen, und
- das silikatbasierte Phosphorpulver (92) konfiguriert ist, Licht des zweiten blauen Wellenbands, das von den mehreren zweiten LED-Chips (53, 71-75) abgestrahlt wird, zu absorbieren und Licht mit einer Wellenlänge eines roten Wellenbands im Bereich von 620 nm bis 650 nm abzustrahlen, wobei
- eine weißes Licht emittierende Vorrichtung mit einer Farbrendering-Ausgleichswirkung durch Mischen der Wellenlängen des ersten blauen Wellenbands und des zweiten blauen Wellenbands, des grünen Wellenbands und des roten Wellenbands erzielt wird.

2. Lichtemittierende Vorrichtung nach Anspruch 1, wobei dann, wenn ein Wechselstrom, AC, angelegt wird, um die lichtemittierende Vorrichtung anzusteuern, ein erster Teil der mehreren zweiten LED-Chips (71-75) konfiguriert ist, einen Zeitraum der positiven Halbwelle, die in den mindestens einen ersten LED-Chip (77) eingegeben wird, zu steuern, und ein zweiter Teil der mehreren zweiten LED-Chips (71-75) konfiguriert ist, einen Zeitraum der negativen Halbwelle, die in den mindestens einen ersten LED-Chip (77) eingegeben wird, zu steuern, wodurch eine Spannungsausgleichswirkung erzielt wird.

3. Lichtemittierende Vorrichtung nach Anspruch 1, wobei der mindestens eine erste LED-Chip (52, 77) durch eine Reihenschaltung mehrerer Mikro-LED-Chips gebildet ist.

4. Lichtemittierende Vorrichtung nach Anspruch 3, wobei die in Reihe geschalteten Mikro-LED-Chips sich auf eine Anordnungseinheit, die durch Verbinden von zwei Mikrochips mit entgegengesetzten Elektroden gebildet ist, beziehen.

5. Lichtemittierende Vorrichtung nach Anspruch 4, wobei die zwei Mikrochips entgegengesetzt verbundene Elektroden besitzen und konfiguriert sind, abwechselnd Licht abzustrahlen.

6. Lichtemittierende Vorrichtung nach Anspruch 1, wobei die mehreren zweiten LED-Chips (53, 71-75) bzw. der mindestens eine erste LED-Chip (52, 77) auf verschiedenen Substraten hergestellt sind.

7. Lichtemittierende Vorrichtung nach Anspruch 6, wobei die mehreren zweiten LED-Chips (53, 71-75) aus einem GaN-basierten Halbleitermaterial hergestellt sind.

8. Lichtemittierende Vorrichtung nach Anspruch 5, wobei die mehreren zweiten LED-Chips (53, 71-75) aus einem Halbleitermaterial hergestellt sind, das aus der Sammlung einer InN-basierten Verbindung, einer GalnAIP-basierten Verbindung, einer GaAlAs-basierten Verbindung, einer GaAlP-basierten Verbindung und einer GaP-basierten Verbindung gewählt ist.

9. Lichtemittierende Vorrichtung nach Anspruch 2, wobei der Leiterrahmen (51) mehrere gedruckte Schaltungen enthält, die Verbindungsflächen besitzen.

## Revendications

1. Dispositif électroluminescent configuré pour être piloté par un courant alternatif, AC, ayant des périodes de demi-ondes positives et négatives, le dispositif électroluminescent comportant :
- une grille de connexion (51),
- au moins une première puce à LED (52, 77) formée sur la grille de connexion (51) ; et
- un circuit de compensation ;
**caractérisé en ce que**
- le circuit de compensation comporte une pluralité de secondes puces à LED (53, 71-75) agencées sous la forme d'un circuit redresseur en pont sur la grille de connexion (51) et électriquement connectées en série à la première puce à LED (52, 77), la pluralité de secondes puces à LED (53, 71-75) étant séparée de la au moins une première puce à LED (52, 77) ;
- la au moins une première puce à LED (52, 77) est constituée de GaN et est configurée pour émettre une longueur d'onde d'émission de lumière d'une première gamme d'ondes du bleu comprise entre 455 nm et 460 nm et la pluralité de secondes puces à LED (53, 71-75) est configurée pour émettre une longueur d'onde d'émission de lumière d'une seconde gamme d'ondes du bleu comprise entre 490 nm et 510 nm ;
- le dispositif électroluminescent comportant en outre :
- une poudre de luminophore YAG (91), une poudre de luminophore à base de silicate (92) et un matériau d'encapsulation du silicium (93) mélangés uniformément et comprimés sur la au moins une première puce à LED (52, 77) et la pluralité de secondes puces à LED (53, 71-75) et la grille de connexion (51),
- dans lequel la poudre de luminophore YAG (91) est configurée pour absorber une portion de lumière de la première gamme d'onde du bleu émise à partir de la au moins une première puce à LED (52, 77) et pour émettre une lumière avec une longueur d'onde d'une gamme d'ondes du vert comprise entre 550 nm et 570 nm,
- dans lequel la poudre de luminophore à base de silicate (92) est configurée pour absorber une lumière de la seconde gamme d'ondes du bleu émise à partir de la pluralité de secondes puces à LED (53, 71-75) et pour émettre une lumière avec une longueur d'onde d'une gamme d'ondes du rouge comprise entre 620 nm et 650 nm,
- dans lequel un dispositif d'émission de lumière blanche avec un effet de compensation de rendu des couleurs est obtenu en mélangeant les longueurs d'onde de la première gamme d'ondes du bleu et de la seconde gamme d'ondes du bleu, de la gamme d'ondes du vert et de la gamme d'ondes du rouge.

2. Dispositif électroluminescent selon la revendication 1, dans lequel lorsqu'un courant alternatif, AC, est appliqué pour piloter le dispositif électroluminescent, une première partie de la pluralité de secondes puces à LED (71-75) est configurée pour commander une période de demi-onde positive appliquée à la au moins une première puce à LED (77), et une seconde partie de la pluralité de secondes puces à LED (71-75) est configurée pour commander une période de demi-onde négative appliquée à la au moins une première puce à LED (77), en obtenant ainsi un effet de compensation de tension.

3. Dispositif électroluminescent selon la revendication 1, dans lequel la au moins première puce à LED (52, 77) est formée en connectant en série une pluralité de micropuces à LED.

4. Dispositif électroluminescent selon la revendication 3, dans lequel les micropuces à LED connectées en série se rapportent à une unité d'assemblage formée en connectant deux micropuces à électrodes opposées.

5. Dispositif électroluminescent selon la revendication 4, dans lequel les deux micropuces ont des électrodes connectées de manière opposée et sont configurées pour émettre des lumières de manière alternée.

6. Dispositif électroluminescent selon la revendication 1, dans lequel la pluralité de secondes puces à LED (53, 71-75) et la au moins une première puce à LED (52, 77) sont respectivement fabriquées sur différents substrats.

7. Dispositif électroluminescent selon la revendication 6, dans lequel la pluralité de secondes puces à LED (53, 71-75) est constituée d'un matériau semi-conducteur à base de GaN.

8. Dispositif électroluminescent selon la revendication 5, dans lequel la pluralité de secondes puces à LED (53, 71-75) est constituée d'un matériau semi-conducteur choisi parmi le groupe constitué d'un composé à base d'InN, d'un composé à base de GaInAlP, d'un composé à base de GaAlAs, d'un composé à base de GaAlP et d'un composé à base de GaP.

9. Dispositif électroluminescent selon la revendication 2, dans lequel la grille de connexion (51) inclut une pluralité de circuits imprimés ayant des plots de connexion.
